# EUROPÄISCHE PATENTANMELDUNG

(11) **EP 1 522 560 A1**
(43) Veröffentlichungstag der Anmeldung: **13.04.2005**
(21) Anmeldenummer: 04023016.1
(22) Anmeldetag: 28.09.2004
(51) Int. Cl.: C09D 5/03, C09D 4/06

(54) **Strahlenhärtende Carbonsäureester enthaltende Bindemittel**

(30) Priorität: 10.10.2003 DE 10347087
(71) Anmelder: Bayer MaterialScience AG, 51368 Leverkusen (DE)
(72) Erfinder: Fäcke, Thomas, Dr., Bridgeville PA 15017 (US); Weikard, Jan, Dr., 51519 Odenthal (DE); Thometzek, Peter, Dr., 70329 Stuttgart (DE)

(57) **Zusammenfassung**

Die vorliegende Erfindung betrifft neue strahlenhärtende Pulverlackbindemittel, die Maleinund/oder Fumarsäureester enthalten, sowie die Verwendung dieser Bindemittel als Bestandteil von Beschichtungsmitteln.

## Beschreibung

Die vorliegende Erfindung betrifft neue strahlenhärtende Pulverlackbindemittel, die Maleinund/oder Fumarsäureester enthalten, sowie die Verwendung dieser Bindemittel als Bestandteil von Beschichtungsmitteln.

Die Verwendung strahlenhärtender pulverförmiger Bindemittel bietet den prinzipbedingten Vorteil gegenüber thermisch härtenden Pulvern, dass Verlauf und Härtung getrennt steuerbar sind. Es ist daher üblich, zunächst den applizierten Pulverlack aufzuschmelzen, genügend Zeit zu erlauben, um einen gewünschten Verlauf zu ermöglichen und danach mittels energiereicher aktinischer Strahlung auszuhärten.

Um auch temperaturempfindliche Substrate beschichten zu können, sollte der Schritt des Aufschmelzens bei möglichst niedrigen Temperaturen (≤ 120°C) und kurzer Zeitdauer möglich sein, um einen guten Verlauf des Beschichtungsmittels zu gewährleisten und das Substrat nicht zu schädigen.

Strahlenhärtende Bindemittel basieren auf den in der Pulverlackchemie bekannten chemischen Systemen wie acrylfunktionellen Polyestern oder Polyacrylaten. Für besonders hochwertige Beschichtungen werden Urethanacrylate verwendet.

Während EP-A 410 242 die Herstellung derartiger Bindemittel in organischen Lösungsmitteln beschreibt, lehrt DE 199 398 43 die lösungsmittelfreie Herstellung unter Verwendung eines hohen Massenanteils von 10 - 95 Gew.-% einer kristallinen Komponente, die aus einem Mono- oder Diisocyanat und einem Mono-Hydroxyalkyl(meth)acrylat aufgebaut ist. Obwohl sehr gute Beschichtungseigenschaften erhalten wurden, ist die Lagerstabilität dieser Pulverlacke schlecht. Im Mahlund Siebprozess verbackt das Pulver, so dass eine industrielle Anwendung nur bei nicht praxisgerechten gekühlten Umgebungstemperaturen möglich ist.

WO-A 03 044 111 beschreibt bei Raumtemperatur mahlbare, lagerstabile, pulverförmige amorphe Urethanacrylate, die keine Tendenz zum Verbacken haben und nach Aufschmelzen besonders niedrigviskos sind. Die Glastemperaturen dieser Verbindungen liegen oberhalb 45°C. Um einen guten Verlauf der beschriebenen Pulverlackbindemittel zu erhalten sind Aufschmelztemperaturen über 120°C notwendig, die für einige wichtige Substrate wie bestimmte Kunststoffe und Holzarten zu hoch sind.

Die der Erfindung zugrunde liegende Aufgabe bestand daher darin, die bekannten strahlenhärtenden Pulverlacksysteme dahingehend zu verbessern, dass bereits bei Aufschmelztemperaturen ≤ 120°C zufriedenstellende Verlaufseigenschaften erreicht werden, wobei Mahlbarkeit und Lagerstabilität nicht negativ beeinflusst werden dürfen.

Es wurde nun gefunden, dass bei Raumtemperatur gut mahlbare und lagerstabile Pulverlacke mit dem gewünschten Aufschmelzverhalten erhalten werden, wenn monomere Malein- und/oder Fumarsäureester dem strahlenhärtenden Pulverlack zugesetzt werden.

Gegenstand der Erfindung sind Bindemittelzusammensetzungen mit einer Glasübergangstemperatur T_{g} innerhalb des Bereiches einschließlich der Grenzen von 30 bis 90°C enthaltend
A) einen oder mehrere kristalline Ester der Malein- und/oder Fumarsäure,
B) ein oder mehrere amorphe oder teilkristalline Harze, die mindestens eine unter Einwirkung aktinischer Strahlung mit ethylenisch ungesättigten Verbindungen unter Polymerisation reagierende Gruppe enthalten sowie
C) gegebenenfalls Hilfs- oder Zusatzstoffe.

Unter aktinischer Strahlung wird elektromagnetische, ionisierende Strahlung verstanden, insbesondere Elektronenstrahlen, UV-Strahlen sowie sichtbares Licht (Roche Lexikon Medizin, 4. Auflage; Urban & Fischer Verlag, München 1999).

Im Sinne dieser Erfindung wird mit Schmelzpunkt diejenige Temperatur bezeichnet, bei der der kristalline Ester der Fumar- oder Maleinsäure (Komponente A) bei 1 bar Atmosphärendruck schmilzt. Im Gegensatz dazu haben amorphe Harze (wie z.B. solche in Komponente B) keinen defmierten Schmelzpunkt. Amorphen Harzen können verschiedene charakteristische Temperaturen zugeordnet werden, in denen die Eigenschaften des Materials sich ändern. Eine davon ist die Glasübergangstemperatur T_{(g)}, die den Übergang vom festen zu einem gummi/zähen Zustand beschreibt. Im Falle von semikristallinen Harzen (solche, die auch in Komponente B Verwendung finden), kann sowohl eine Glasübergangstemperatur Tg als auch ein Schmelzpunkt zugeordnet werden. Letzterer ist immer höher als ersterer. Eine detailliertere Beschreibung ist zu finden bei H.-G. Elias, "An Introduction to Polymer Science", VCH Verlagsgesellschaft, Weinheim, 1997, Kapitel 10.2.4., Moduli and Poisson Ratios', Seiten 330-332.

Als Ester ROOC-CH=CH-COOR' der Malein- bzw. Fumarsäure können in A) sowohl die Halbals auch die Vollester einzeln oder in beliebigen Mischungen untereinander eingesetzt werden. Bevorzugt weisen sie einen Schmelzpunkt innerhalb des Bereiches einschließlich der Grenzen von 20 - 180°C, bevorzugt von 40 - 140°C, besonders bevorzugt von 80 - 135°C auf.

R ist dabei ein gegebenenfalls Heteroatom-enthaltender, gegebenenfalls ungesättigter aliphatischer, cycloaliphatischer, araliphatischer oder aromatischer Rest und R' ist entweder H oder ebenfalls ein gegebenenfalls Heteroatom-enthaltender, gegebenenfalls ungesättigter aliphatischer, cycloaliphatischer, araliphatischer oder aromatischer Rest.

R, R' können grundsätzlich auch funktionelle Gruppen wie Vinyl-, Allyl-, Epoxy-, Cyano-, Isocyanato-, Amino-, Thiol-, Hydroxyl-, Halogen-, Nitro-, Sulfon-, Sulfoxy-, Amid-, Ether-, Ester-, Carbonsäure-, Harnstoff-, Urethan-, Uretdion-, Allophanat-, Biuret-, Isocyanurat-, Thioester-, Thioamid-, Carboxyl-, Carbonyl-, Aryl- und/oder Acylgruppen aufweisen.

Bevorzugt steht R für Methyl, Ethyl, n-Propyl, Isopropyl, n-Butyl, Isobutyl, tert.-Butyl, Pentyl, Hexyl, Heptyl, Octyl, Nonyl, Decyl, Dodecyl, Cycloheptyl oder Cyclohexyl, besonders bevorzugt für Ethyl, Isopropyl, n-Butyl oder Cyclohexyl.

Besonders bevorzugt werden Fumarsäuredialkylester R-OOC-CH₂=CH₂-COOR' mit R = R' = Methyl, Cyclohexyl oder Dodecyl; die Fumarsäurehalbester R-OOC-CH₂=CH₂-COOH mit R = Methyl, Ethyl, Isopropyl, Cyclohexyl, Allyl, Dodecyl, Propargyl oder Butyl; die Maleinsäuredialkylester R-OOC-CH₂=CH₂-COOR' mit R = R' = Cyclohexyl oder Dodecyl; oder die Maleinsäurehalbester R-OOC-CH₂=CH₂-COOH mit R = Ethyl, Isopropyl, Cyclohexyl oder Dodecyl eingesetzt.

Ganz besonders bevorzugt werden ausschließlich die Fumarsäureester, insbesondere die Fumarsäurehalbester der vorstehend genannten Art in A) eingesetzt.

Die in den erfindungsgemäßen Bindemittelzusammensetzungen enthaltenden Malein- bzw. Fumarsäureester sind nach EP-A 69 926 technisch leicht durch Umsetzung von Maleinsäureanhydrid mit dem entsprechenden Alkohol oder -gemisch und gegebenenfalls anschließender Isomerisierung zugänglich.

Komponente B) enthält ein oder mehrere amorphe oder teilkristalline Harze, die mindestens eine unter Einwirkung aktinischer Strahlung polymerisierbare Gruppe enthalten. Solche Harze sind beispielsweise Polyester, Polycarbonate, Polyacrylate, Polyether, Polyurethane oder Polyamide oder beliebige Mischungen solcher Polymere, die mindestens eine unter Einwirkung aktinischer Strahlung polymerisierbare Gruppe enthalten.

Durch aktinische Strahlung polymerisierbare Gruppen können beispielsweise Vinyl-, Vinylether-, Propenyl-, Allyl-, Maleinyl-, Fumaryl-, Maleinimid-, Dicyclopentadienyl-, Acrylamid-, Acryl- und Methacryl-Gruppen sein, bevorzugt sind Vinylether-, Acryl- und/oder Methacryl-Gruppen, besonders bevorzugt sind Acrylgruppen.

Geeignete Polyester oder Polyamide werden üblicherweise durch Umsetzung ungesättigter Säuren bzw. Anhydride wie Maleinsäure(anhydrid) und Fumarsäure mit mehrfach OH- und/oder oder NH-funktionellen Verbindungen erhalten.

Geeignete Polyester, Polycarbonate oder Polyurethane sind beispielsweise durch Umsetzung ungesättigter OH-funktioneller Verbindungen mit 2 bis 12, vorzugsweise 2 bis 4 Kohlenstoffatomen mit beispielsweise Säure-, Ester- oder Säurechlorid-funktionellen Polyestern oder Polycarbonaten oder NCO-funktionellen Polyurethanen zugänglich.

Beispiele für geeignete ungesättigte OH-funktionelle Verbindungen sind Hydroxyethyl(meth)-acrylat, 2- und 3-Hydroxypropyl(meth)acrylat, 2-, 3- und 4-Hydroxybutyl(meth)acrylat, weiterhin OH funktionelle Vinylether, wie z.B. Hydroxybutylvinylether sowie deren Mischungen.

Des weiteren können als OH-funktionelle ungesättigte Verbindungen OH-funktionelle (Meth)acrylsäureester bzw. -amide eingesetzt werden, die durch Umsetzung von bis zu n-1 Äquivalenten (Meth)acrylsäure mit n-wertigen Alkoholen, Aminen, Aminoalkoholen und/oder deren Gemischen erhältlich sind. Als n-wertige Alkohole kommen dabei Glycerin, Trimethylolpropan und/oder Pentaerythrit infrage.

Ebenfalls können Produkte aus der Umsetzung von epoxyfunktionellen (Meth)acrylsäureester mit (Meth)Acrylsäure verwendet werden. So ergibt die Umsetzung von Glycidylmethacrylat mit Acrylsäure einen gemischten Acrylsäure- Methacrylsäureester des Glycerins, der ebenfalls vorteilhaft verwendet werden kann.

Geeignet sind auch Umsetzungsprodukte von Polyestern mit Säurezahlen >5 und glycidylfunktionellen (Meth-)acrylaten (z.B. Glycidylmethacrylat).

Bevorzugt sind als OH-funktionelle ungesättigte Verbindungen zum Aufbau ungesättigter Polyester, Polycarbonate und Polyurethane ist Hydroxyethylacrylat und die isomeren Hydroxypropylacrylate.

Polyacrylate können nur nach der Polymerisation der Acrylat- und Vinylaromatenmonomere strahlenhärtend modifiziert werden. Dies gelingt über funktionelle Gruppen, die inert gegenüber den Herstellungsbedingungen des Polyacrylats sind und anschließend erst zu ungesättigten strahlenhärtenden Gruppen weiter modifiziert werden. Geeignete Gruppen hierzu sind beispielsweise

| Inerte Gruppe | Modifizierungsreagenz | Strahlenhärtende Gruppe |
|---|---|---|
| Epoxy | Acrylsäure, dimere Acrylsäure | Acrylat |
| Säure | Glycidylmethacrylat | Methacrylat |
| Säure | Hydroxyalkylacrylat | Acrylat |
| Alkohol | Maleinsäureanhydrid | Maleinat |
| Alkohol | Acrylsäure, dimere Acrylsäure | Acrylat |
| Alkohol | Acrylfunktionelles Isocyanat | Urethanacrylat |
| Isocyanat | Hydroxyalkylacrylat | Urethanacrylat |
| Anhydrid | Hydroxyalkylacrylat | Acrylat |

Verschiedene amorphe oder teilkristalline Harze, die mindestens eine unter Einwirkung aktinischer Strahlung polymerisierbare Gruppe enthalten, sind auch kommerziell erhältlich. Beispiele sind die Produkte der UVECOAT® -Reihe der Fa. UCB S.A., BE und die Produkte der URACROSS® P-Reihe der Fa. DSM N.V., NL.

Als Komponente C) können in der Technologie der Lacke, Farben, Druckfarben, Dichtstoffe und Klebstoffe übliche Zusätze oder Hilfsmittel enthalten sein. Dazu gehören auch durch aktinische Strahlung aktivierbare Initiatoren, die eine radikalische Polymerisation der entsprechenden polymerisierbaren Gruppen auslösen. Fotoinitiatoren, die durch UV- oder sichtbares Licht aktiviert werden, sind hierbei bevorzugt. Fotoinitiatoren sind an sich bekannte, kommerziell vertriebene Verbindungen, wobei zwischen unimolekularen (Typ I) und bimolekularen (Typ II) Initiatoren unterschieden wird. Geeignete (Typ I)-Systeme sind z.B. aromatische Ketonverbindungen, z.B. Benzophenone in Kombination mit tertiären Aminen, Alkylbenzophenone, 4,4'-Bis(dimethylamino)benzophenon (Michlers Keton), Anthron und halogenierte Benzophenone oder Mischungen der genannten Typen. Weiter geeignet sind (Typ II)-Initiatoren wie z.B. Benzoin und seine Derivate, Benzilketale, Acylphosphinoxide z.B. 2,4,6-Trimethyl-benzoyl-diphenylphosphinoxid, Bisacylphosphinoxide, Phenylglyoxylsäureester, Campherchinon, α-Aminoalkylphenone, α,α-Dialkoxyacetophenone und α-Hydroxyalkylphenone. Es können auch Gemische dieser Verbindungen eingesetzt werden. Bevorzugt werden solche Verbindungen, die sich mit den Methoden der Pulverlacktechnik gut einarbeiten lassen und nicht zu einer Reduktion der Lagerstabilität oder Mahlbarkeit der Bindemittel fuhren. Beispiele hierfür sind 1-Hydroxycyclohexylphenylketon, Benzidimethylketal oder ― bei pigmentierten Systemen ― 2-Methyl-1-(4-(methythio)phenyl-2-morpholino-propanon-1 oder Trimethyl-benzoyl-diphenyl-phosphinoxid.

Soll die Härtung der polymerisierbaren Bestandteile zusätzlich thermisch initiiert werden, eignen sich als Verbindungen der Komponente C Peroxyverbindungen wie Diacylperoxide z.B. Benzoylperoxid, Alkylhydroperoxid wie Diisopropylbenzolmonohydroperoxid, Alkylperester wie tert.-Butylperbenzoat, Dialkylperoxide wie Di.-tertbutylperoxid, Peroxidicarbonate wie Dicetylperoxiddicarbonat, anorganische Peroxide wie Ammoniumperoxodisulfat, Kaliumperoxodisulfat oder auch Azoverbindungen wie 2,2'-Azobis[N-(2-propenyl)-2-methylpropionamide], 1-[(Cyano-1-methylethyl)azo]formamide, 2,2'-Azobis(N-butyl-2-methylpropionamide), 2,2'-Azobis(N-cyclohexyl-2-methylpropionamide), 2,2'-Azobis{2-methyl-N-[2-(1-hydroxybutyl)]propionamide}, 2,2'-Azobis{2-methyl-N-[2-(1-hydroxybutyl)]propionamide, 2,2'-Azobis{2-methyl-N-[1,1-bis(hydroxymethyl)-2-hydroxyethyl]propionamide, weiterhin auch Benzpinakol. Diese Radikalbildner können in bekannter Weise mit Beschleunigern kombiniert werden z.B. mit Cobaltverbindungen und/oder aromatischen Aminen.

Weiterhin verwendbare Zusätze sind Stabilisatoren, Lichtschutzmittel wie UV-Absorber und sterisch gehinderte Amine (HALS), weiterhin Antioxidantien, Füllstoffe sowie Lackhilfsmittel, z.B. Antiabsetzmittel, Entschäumungs- und/oder Netzmittel, Verlaufmittel, Reaktivverdünner, Weichmacher, Katalysatoren und/oder Verdicker sowie Pigmente, Farbstoffe und/oder Mattierungsmittel. Der Einsatz von Lichtschutzmitteln und die verschiedenen Typen sind beispielhaft beschrieben in A. Valet, Lichtschutzmittel für Lacke, Vincentz Verlag, Hannover, 1996.

Ein weiterer Gegenstand der Erfindung ist ein Verfahren zur Herstellung der erfindungsgemäßen Bindemittelzusammensetzungen, bei dem die Komponenten A) bis C) in beliebiger Reihenfolge oder als Mischung unter Rühren, Kneten oder sonstigem Vermischen bei Temperaturen von 40 bis 140°C, vorzugsweise 60 bis 120°C miteinander vermischt werden und abschließend zu einem Granulat zerkleinert werden.

Zur Vermischung eignen sich beispielsweise Extrudern oder Knetern, bevorzugt werden Extruder verwendet.

Die Extrusionsbedingungen liegen dabei in einem Temperaturbereich in dem die Bestandteile der Komponente B) bereits erweichen, also oberhalb der Glasübergangstemperatur T_{g} von B), jedoch noch unterhalb Schmelzpunkts Tₘ der Komponente A). Extrusionsbedingungen oberhalb des Schmelzpunktes T_{M} von A) sind auch möglich, aber nur dann wenn eine Rekristallisation der Ester A) nach der Extrusion aus dem Gemisch stattfindet. Ebenfalls ist es möglich auf ein gemeinschaftliches Extrudieren zu verzichten und A) und B) getrennt voneinander zu mahlen, zu sieben und durch einfaches Mischen der Pulver zu vermengen.

Die Komponente C) kann dabei vor dem Vermischen zu einer der Komponenten A) oder B) gegeben werden oder während oder nach der Vermischung der Komponenten A) und B) zugefügt werden.

Die Granulierung erfolgt in an sich in bekannter Weise beispielsweise durch Mahlen und anschließendes Sieben zur Entfernung von groben oder zu feinem Kornanteilen. Bevorzugt weisen die Bindemittelzusammensetzungen nach dem Mahlen eine mittlere Korngröße von weniger als 200 µm , besonders bevorzugt kleiner 100 µm auf.

Die so hergestellten pulverförmigen Bindemittelzusammensetzungen können nach üblichen Pulverauftragsverfahren, wie z.B. elektrostatischen Pulversprühen, turboelektrischem Auftrag, elektromagnetischen Bürsten oder Wirbelsintern, auf die zu überziehenden Formteile aufgebracht werden. Die Überzüge werden dann zunächst durch Einwirkung von Hitze (z. B. durch IR-Strahler und/oder in Umluft- bzw. Konvektionsöfen) geschmolzen. Es bildet sich ein klarer Film, sofern keine Pigmente o. ä. eingearbeitet wurden. Die Härtung der Überzüge kann entweder durch Erhitzen auf 130-220°C, vorzugsweise 150-190°C, und/oder durch die Einwirkung von energiereicher Strahlung wie UV- oder Elektronenstrahlung erfolgen. In letzteren bevorzugten Fall wird nur eine niedrige Temperatur zum Aufschmelzen benötigt. Diese liegt bevorzugt ≤ 120°C, besonders bevorzugt ≤ 100°C, ganz besonders bevorzugt ≤ 90°C, wobei die Aufschmelzdauer bevorzugt ≤ 20 min, besonders bevorzugt ≤ 15 min, ganz besonders bevorzugt ≤ 10 min beträgt.

Im Falle der Vernetzung mittels UV-Strahlung ist es notwendig, in Komponente C) Fotoinitiatoren homogen einzuarbeiten. Als Fotoinitiatoren sind die üblicherweise eingesetzten Verbindungen geeignet, wenn sie die Pulvereigenschaften wie Rieselfähigkeit und Lagerfähigkeit nicht negativ beeinflussen.

Die bei C) genannten Fotoinitiatoren, die in Mengen zwischen 0,1 und 10 Gew.-%, vorzugsweise 0,1 bis 5 Gew.-%, bezogen auf das Gewicht des Bindemittels, eingesetzt werden, können als einzelne Substanz oder, wegen häufiger vorteilhafter synergistischer Effekte, auch in Kombination miteinander verwendet werden.

Gegenstand der Erfindung ist weiterhin die Verwendung der erfmdungsgemäß hergestellten Bindemittel für Pulverlacke zur Beschichtung von Substraten aus Holz, Metall, Kunststoff, mineralischen Stoffen oder bereits beschichteten Substraten oder von Substraten, die aus beliebigen Kombinationen der genannten Materialen bestehen: Insbesondere seien hier Anwendungen in der Industrielackierung von MDF-Platten, vormontierten höherwertigen Gütern, die bereits temperaturempfindliche Baugruppen enthalten aber auch die Lackierung von Möbeln, Coils, Gegenständen des täglichen Lebens, Automobilkarossen und deren Anbauteile genannt. Auch Kompositmaterialen aufgebaut aus Kunststoff und Metall sind geeignete Substrate.

Insbesondere auf Metall- oder Kunststoffteilen kann die Verwendung der Ester A), die noch freie Carboxylatgruppen aufweist zu einer besonders guten Haftung fuhren.

### Beispiele:

In den nachfolgenden Beispielen beziehen sich alle Prozentangaben auf das Gewicht.

Die Glasübergangstemperatur T_{g} wurde mit einem Differential Scanning Kalorimeter (Typ DSC 12E, Metler-Toledo GmbH, Giessen, DE) in einem Temperaturintervall von ―15°C bis + 150°C (Aufheizrate 10K/Minute) bestimmt.

Die angegebenen Schmelzpunkte in °C wurden mit einem Kapillar-Schmelzpunkt-Messgerät (Typ Büchi 530, Büchi Labortechnik AG, CH-9230 Flawil) bestimmt.

Die Ermittlung des NCO-Gehaltes erfolgte durch Titration gemäß DIN 53 185.

### Beispiel 1

### Amorphes Urethanacrylatharz

In einem Planschlifftopf wurden 2425.70g Desmodur I [1-Isocyanato-3-Isocyanatomethyl-3,5,5-trimethylcyclohexan (IPDI)] (Bayer AG, Leverkusen, DE) vorgelegt und bei 90°C 1.60 g 2,5-Ditert.-butylhydrochinon, 4.00 g 2,6-Di-tert.-butyl-4-methylphenol, 2.00 g Desmorapid Z (Dibutylzinndilaurat) (Bayer AG, Leverkusen, DE) und 4.00 g p-Methoxyphenol gelöst. Nun wurde unter Wärmeentwicklung eine Mischung aus 1179.24 g Hydroxypropylacrylat und 383.46 g 1,2-Ethandiol innerhalb von 3 h zudosiert, die Temperatur wurde dabei bei 90°C gehalten. Mit zunehmender Viskosität der Harzschmelze wurde bis auf 116°C erwärmt. Nach 1,5 h Rühren wurde ein NCO-Gehalt 0,05 Gew.-% erreicht. Die Schmelze wurde in einer Aluschale überführt und man ließ diese erkalten. Die Glastemperatur T_{g} des amorphen, glasharten, spröden Produkts betrug 49,2°C.

### Beispiel 2

### Kristalliner monomerer Fumarsäuremonocyclohexylester

In die Lösung von 196 g Maleinsäureanhydrid und 2 g Jod in 200 g eines technischen Alkyl-Aromaten-Gemisches als Lösungsmittel wurden bei 160°C im Verlaufe von 50 Minuten 200 g Cyclohexanol eingetropft. Das Reaktionsgemisch wurde heiß filtriert, im Wasserstrahlvakuum eingedampft und der Rückstand aus Leichtbenzin/Toluol umkristallisiert. Man erhielt den Fumarsäurecyclohexylmonoester in farblosen Kristallen mit einem Schmelzpunkt Tₘ von 87°C.

### Beispiel 3

### Herstellung der Beschichtungen

Das Produkt aus Beispiel 1 (Komponente B) wurde mit einem Hexler der Firma Alpine, Augsburg, DE, Typ CA 80 a―2 gehexelt. Die gehexelte Komponente B) und der Fumarsäureester aus Beispiel 2 (Komponente A) wurden getrennt auf einer Mühle Neumann & Esser GmbH, Übach-Palenberg, DE Typ ICM 4 gemahlen (Sichter 20 m/s, Rotor 80 m/s) und mit einem 120 µm Sieb gesiebt. In einem Premixgefäß wurden 91,25 Gew.-% der zerkleinerten Komponente B), 7,00 % der zerkleinertem Komponente A), 1,0 Gew.-% Worlee Add 101 (Worlee-Chemie GmbH, Lauenburg, DE) als Verlaufshilfsmittel und 0,75 Gew.-% Photoinitiator Irgacure® 2959 (Ciba Specialty Chemicals Inc., Basel, CH) eingewogen und in einem Premixer Prism Pilot 3, Prism Ltd., Lichfield, Staffordshire, UK (Premixereinstellung: 20 s, 1200 rpm) vorgemischt. Anschließend wurde in einem Extruder APV MP19-15PC, APV Baker Ltd., Newcastle-under-Lyme, Staffordshire, UK mit den Temperatureinstellungen Zone 1 Sollwert 35°C/ Zone 2 Sollwert 40°C / Drehzahl der Wellen: 150 rpm / gemessene Temperatur der Schmelze 53°C / Dosierungseinstellung 5,0 / Auslastung am Extruder durchschnittlich 55 % extrudiert. Die so erhaltenen Chips wurden auf einer Mühle der Firma Neumann & Esser, Übach-Palenberg, DE, Typ ICM 4 gemahlen (Sichter 20 m/s, Rotor 80 m/s), mit einem 120 µm Sieb gesiebt und umgehend mit einer Spritzpistole ITW Gema, ITW Gema AG, St. Gallen, CH (50-60 mV, Druck variabel, Dosierung variabel) auf grau beschichtetes Coilcoat Blech (Coil-Coating Blech grau 100 x 200 mm, Zanders, Solingen, DE) gesprüht. Im Umluftofen wurde wie in Tabelle 1 angegeben der Film aufgeschmolzen und das heiße Coilcoat Blech anschließend mit UV-Licht mit einem Gerät IST S131 P-7FO, Weiner & Pfleicherer-Hildebrand Strahlentechnik GmbH, Oberbohlingen, DE (CK normal 2, Bandgeschwindigkeit 10m/min) bestrahlt. Der Film war sofort hart und wurde nach Abkühlen auf Raumtemperatur und 60 min. Lagerung beurteilt. Die Lösemittelfestigkeit wurde mittels eines in Aceton getränkten Wattebausches, der mit einem Andruck von ca. 1 kg in 100 Doppelhüben über den Film bewegt wurde, beurteilt. Die Glanzmessung erfolgte mit einem Glanzmessgerät micro-TRI-gloss, BYK-Gardner GmbH, 82538 Geretsried, DE nach DIN 67530 im Winkel von 60 und 85°.

Die Filme sind lösemittel- und kratzfest und zeigen die in Tabelle 1 angegebenen Verlaufs- und Glanzeigenschaften.

**Tabelle 1:**

| Beschichtungsversuche | | | | | | |
|---|---|---|---|---|---|---|
| Versuch | Zeit/Min. | Temp./°C | Schicht/µm | Glanz 60°/85° | Verlauf | Aceton |
| 1 | 5 | 100 | 66-103 | 83,5/95,5 | Gut | 0 |
| 2 | 10 | 100 | 53-65 | 83,2/97,1 | Gut | 0 |
| 3 | 10 | 90 | 61-83 | 88,1/92,5 | Gut | 0 |
| 4 | 15 | 80 | 62-92 | 87,9/91,7 | Gut | 0 |
| 5 | 5 | 120 | 66-80 | 90,0/101,1 | Sehr Gut | 0 |

Die Beschichtungsversuche zeigen, dass die erfindungsgemäßen Beschichtungsmittel selbst bei 80°C noch zu hochglänzenden Beschichtungen hoher Oberflächenqualität verlaufen.

## Patentansprüche

1. Bindemittelzusammensetzungen mit einer Glasübergangstemperatur T_{g} innerhalb des Bereiches einschließlich der Grenzen von 30 bis 90°C enthaltend
A) einen oder mehrere kristalline Ester der Malein- und/oder Fumarsäure,
B) ein oder mehrere amorphe oder teilkristalline Harze, die mindestens eine unter Einwirkung aktinischer Strahlung mit ethylenisch ungesättigten Verbindungen unter Polymerisation reagierende Gruppe enthalten sowie
C) gegebenenfalls Hilfs- oder Zusatzstoffe.

2. Bindemittelzusammensetzungen gemäß Anspruch 1, **dadurch gekennzeichnet, dass** die Komponente A) einen Schmelzpunkt innerhalb des Bereiches einschließlich der Grenzen von 20 - 180°C hat.

3. Bindemittelzusammensetzungen gemäß Anspruch 1 oder 2, **dadurch gekennzeichnet, dass** die Komponente A) mindestens einen Malein- oder Fumarsäurehalbester enthält.

4. Verfahren zur Herstellung der Bindemittelzusammensetzungen gemäß einem der Ansprüche 1 - 3, bei dem die gegebenenfalls zuvor zerkleinerten Bestandteile der Komponenten A) bis C) in beliebiger Reihenfolge bei Temperaturen von 40 bis 140°C miteinander homogen vermischt und abschließend zu einem Granulat zerkleinert werden.

5. Verfahren nach Anspruch 4, **dadurch gekennzeichnet, dass** für die Zerkleinerungsschritte Häcksler und/oder Mühlen verwendet werden und die Vermischung mittels Extruder erfolgt.

6. Verwendung der Bindemittelzusammensetzungen nach einem der Ansprüche 1 - 3 zur Herstellung von Beschichtungen.

7. Beschichtungen erhältlich aus Bindemittelzusammensetzungen nach einem der Ansprüche 1-3.

8. Substrate beschichtet mit Beschichtungen nach Anspruch 7.
